**Europäisches Patentamt**

**European Patent Office**

**Office européen des brevets**

(19)

(11) Publication number: **0 088 591**
A2

(12) # EUROPEAN PATENT APPLICATION

(21) Application number: **83301129.9**

(22) Date of filing: **03.03.83**

(51) Int. Cl.³: **G 07 C 3/14,** B 07 C 5/34

(30) Priority: **06.03.82 GB 8206654**

(43) Date of publication of application: **14.09.83** Bulletin 83/37

(84) Designated Contracting States: **DE FR NL SE**

(71) Applicant: **PLESSEY OVERSEAS LIMITED, Vicarage Lane, Ilford Essex IGI 4AQ (GB)**

(72) Inventor: **Reeves, Alfred, 37 Village Way Wallasey Village, Wallasey Merseyside L45 3NY (GB)**

(74) Representative: **Hart, Robert John, Plessey Telecommunications plc Edge Lane, Liverpool L7 9NW (GB)**

(54) **On board memory for multi component manufacturing products.**

(57) In the modern world of electronic design the equipment is becoming smaller and smaller and the manufacture and production departments are finding it more and more difficult to fix control labels, serial numbers, fault labels, progress data etc. to the product during its manufacturing process. The proposal is that each product (printed circuit card in the specific application to Telephone Exchange production) carries a programmable read only memory dedicated to the storage of the manufacture/production information only. Such a device requires only one i.c. (of the order of 1 1/2'' × 1/2'') and some access pins on the pcb connector. The incorporation of such a device allows it to be used to condition automatic component assembly equipment and automatic testing equipment for example. In addition the memory can be used to store "working" data such as routine maintentance information or replaced faulty component information. The equipment for reading and writing to the product's memory is not resident on the product but would be available when the memory requires to be read or modified. The basic concept is applicable to a wide range of complex products which require the assembly of a large number of component parts.

- 1 -

TITLE:  <u>MULTI-COMPONENT MANUFACTURED PRODUCTS</u>

The present invention relates to multi-component manufactured products and is more particularly concerned with an arrangement for the provision of manufacturing and constructional progress information to accompany the products.

In multi-component manufactured products, for example printed circuit boards carrying electronic components, there is a requirement, during the assembly and testing of the product, for manufacturing control information to accompany the product through its various stages of construction and manufacture.  In the case of printed circuit boards, for use in say the production of an electronic telephone exchange, the bare board carrying only the printed circuit tracks is introduced into the manufacturing process and identified as to circuit type by the manual application of a printed label to the board.  The label may either be an alpha/numeric or a bar coded label which is used thereafter to identify the printed circuit board type, and therefore the components required for its assembly, as it passes through the stages of the manufacturing process.  At each stage of the manufacturing process it is customary for control labels bearing the identity of the machine or operator involved in that stage, and for the results of say a testing operation, to be affixed in some way to the products so that production control personnel can identify the "route" through the stages of the production process taken by each manufactured product (printed circuit board). In the modern world, particularly in the field of electronic design, equipment is becoming smaller and smaller and it is becoming more and more difficult to find space on the manufactured product for the control labels to be affixed.

According to the invention there is provided a multi-component manufactured product incorporating an on-board memory adapted to co-operate with external equipment which is arranged (a) to write into the memory information indicative of production control information relative to the manufactured product and (b) to read stored production control information from the memory during the passage of the product between the production process stages.

The information held in the "on-board" memory will define the product type and can form the basis for the control of the automatic assembly and testing of the component parts of the manufactured product.

The invention will be more readily understood from the following description of one embodiment involving a printed circuit board for use in a telephone exchange.

The coded identity of that board is written into an on-board read only memory as the first stage of the production process after the production of the bare p.c.b. The coded identity is read out from the on-board memory and is used to condition automatically, the component insertion machine to select and thereafter insert the required components constituting the electronic equipment formed by that printed circuit board. Upon completion of the component assembly operation, the identity of the automatic component insertion machine is written into the on-board memory and the part-fabricated equipment board is passed onto the next stage of the manufacturing process. At each stage of the process the printed circuit board will be fitted into a printed circuit board connector which allows electrical connection to the on-board memory access and control equipment. The on-board memory is connected to "spare" printed circuit board connector pins which are dedicated for use by the stages of the manufacturing process.

Typically the next stage after component assembly involves the testing of the components inserted onto the printed circuit card. The use of the on-board memory allows that memory to identify to an automatic tester the routine it is to perform. The on-board memory may either (i) simply identify the printed circuit board identity code or (ii) may actually provide the test routine for the automatic tester. In the first case the automatic test equipment includes a bank of test programs and the identity of the printed circuit board is used to control the automatic test equipment to select the required test program or programs. Upon completion of the test operations the identity of any faulty component if any is written into the on-board memory allowing remedial action to be taken as part of the production process before the printed circuit card equipment is passed on to the next stage of the production process.

The on-board memory is also adapted to include information indicative of the destination of the equipment defining, in the case of assembled printed circuit boards, the identity of the telephone exchange for which the equipment board is destined. This information is read and used during the stores sequence of the manufacturing process which may involve an automatic equipment warehousing machine which is used to assemble the completed printed circuit boards into dedicated warehouse areas indicative of either the circuit board type or job number (i.e. telephone exchange identity).

Typically the on-board memory is arranged as a "duplicated" device allowing the information to be recorded twice in separate parts of the memory for memory operation fault recognition purposes. The on-board memory is preferably an electrically programable read only memory device of the type referred to under reference INTEL 2764 which may be arranged to include a read only memory section for permanent information written into the memory during the production process. The on-board memory may be left on the finished product allowing the user to use the memory for "inservice" recorded information. It is important for the on-board memory to be of the programmable type so that separate power sources are not required to support the memory when the printed circuit board equipment is in storage. The on-board space required for such an arrangement is no more than 3.5 cm. x 1.5 cm.

From the above description it can be seen that the provision of an "on-board" memory for a multi-component manufactured product (such as a printed circuit board) provides for the storage of information for all the manufacturing "labels" and production paper work required. In addition the on-board memory can form the basis for the control of insertion of components into the manufactured product, the manufacturing history of the product, quality assurance information, testing information, fault reporting information and finished product despatch information etc. The on-board memory also has the particular advantage that the information is not open to physical damage and corruption in the same sense as paper labels are and the product history is built-in as opposed to the current techniques of rubber stamping of functions such as quality inspection and testing.

Although the embodiment disclosed herein is related to the incorporation of an on-board memory for a printed circuit board equipment it will readily be appreciated that the on-board memory could be applied to other multi-component products such as motor vehicles, aircraft and indeed buildings; in fact in any multi-component product in which one needs to know about the manufacture, life or history of the product.

WHAT WE CLAIM IS:

1.  A multi-component manufactured product incorporating an on-board memory adapted to co-operate with external equipment arranged (a) to write into the memory production control information relative to the manufacture of the manufactured product and (b) to read production control information from the memory to influence the manufacturing process for the product during the passage of the product through the stages of the manufacturing process.

2.  A multi-component manufactured product incorporating an on-board memory as claimed in claim 1 in which the memory is an electrically programmable read only memory device.

3.  A multi-component manufactured product incorporating an on-board memory as claimed in claim 1 or 2 in which the memory is arranged to store the manufacturing identity code for the multi-component manufactured product which is used to identify the particular product during the manufacture process.

4.  A multi-component manufactured product incorporating an on-board memory as claimed in claim 3 in which the memory is arranged to store information indicative of the route taken by the product through the manufacturing process.

5.  A multi-component manufactured product incorporating an on-board memory as claimed in any one of the preceeding claims in which the memory is arranged to store information indicative of the components used in the product and information relating to the testing of those components.

6. A multi-component manufactured product incorporating an on-board memory in which the memory is arranged to store information relating to the quality of the components incorporated in the product.

7. A multi component manufacture product according to any one of the preceding claims in which the product is a printed circuit board and the on-board memory is connected to printed circuit board conector pins which are dedicated to the access and control of the on-board memory device.